(19) Europäisches Patentamt
European Patent Office
Office européen des brevets

(11) **EP 4 009 456 B1**

(12) **FASCICULE DE BREVET EUROPEEN**

(45) Date de publication et mention de la délivrance du brevet:
**19.04.2023 Bulletin 2023/16**

(21) Numéro de dépôt: **21211800.4**

(22) Date de dépôt: **01.12.2021**

(51) Classification Internationale des Brevets (IPC):
**H01S 5/12** *(2021.01)* **H01S 5/20** *(2006.01)*
**H01S 5/22** *(2006.01)* **H01S 5/34** *(2006.01)*

(52) Classification Coopérative des Brevets (CPC):
**H01S 5/12; H01S 5/1231; H01S 5/209; H01S 5/22; H01S 5/2202; H01S 5/3401;** H01S 2301/176

(54) **PROCÉDÉ DE RÉALISATION D'UN MIROIR DE BRAGG DISTRIBUÉ**

VERFAHREN ZUR HERSTELLUNG EINES VERTEILTEN BRAGG-SPIEGELS

METHOD FOR PRODUCING A DISTRIBUTED BRAGG MIRROR

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.12.2020 FR 2012650**

(43) Date de publication de la demande:
**08.06.2022 Bulletin 2022/23**

(73) Titulaire: **Commissariat à l'Energie Atomique et aux Energies Alternatives
75015 Paris (FR)**

(72) Inventeurs:
• **FOURNIER, Maryse
38054 GRENOBLE Cedex 09 (FR)**
• **REBOUD, Vincent
38054 GRENOBLE Cedex 09 (FR)**
• **FEDELI, Jean-Marc
38054 GRENOBLE Cedex 09 (FR)**

(74) Mandataire: **Hautier IP
20, rue de la Liberté
06000 Nice (FR)**

(56) Documents cités:
**WO-A1-2005/122351 US-A1- 2015 333 482
US-A1- 2018 375 293**

• **COUTARD J. G ET AL: "Volume fabrication of Quantum Cascade Lasers on 200 mm-CMOS pilot line", SCIENTIFIC REPORTS , vol. 10, no. 1 1 décembre 2020 (2020-12-01), page 6185, XP055815604, DOI: 10.1038/s41598-020-63106-4 Extrait de l'Internet: URL:https://www.nature.com/articles/s41598 -020-63106-4.pdf**
• **CHEN J Y ET AL: "Single-mode operation of terahertz quantum cascade lasers", INTERNATIONAL SYMPOSIUM ON PHOTOELECTRONIC DETECTION AND IMAGING 2011: TERAHERTZ WAVE TECHNOLOGIES AND APPLICATIONS, SPIE, 1000 20TH ST. BELLINGHAM WA 98225-6705 USA, vol. 8195, no. 1, 9 juin 2011 (2011-06-09) , pages 1-8, XP060016071, DOI: 10.1117/12.900173**
• **CHASTANET D ET AL: "High temperature, single mode, long infrared ([lambda] = 17.8 [mu]m) InAs-based qu", APPLIED PHYSICS LETTERS, A I P PUBLISHING LLC, US, vol. 105, no. 11, 15 septembre 2014 (2014-09-15), XP012190029, ISSN: 0003-6951, DOI: 10.1063/1.4895763 [extrait le 1901-01-01]**

## Description

## DOMAINE TECHNIQUE

La présente invention concerne le domaine de l'optoélectronique. Elle peut être mise en oeuvre pour la réalisation de composants émetteurs de lumière, notamment dans le domaine du moyen infrarouge (MIR). Elle trouve pour application particulièrement avantageuse la réalisation de miroirs de Bragg distribués pour des sources laser à cascade quantique en technologie compatible CMOS. Un exemple d'application particulier concerne les capteurs environnementaux utilisant des sources MIR.

## ETAT DE LA TECHNIQUE

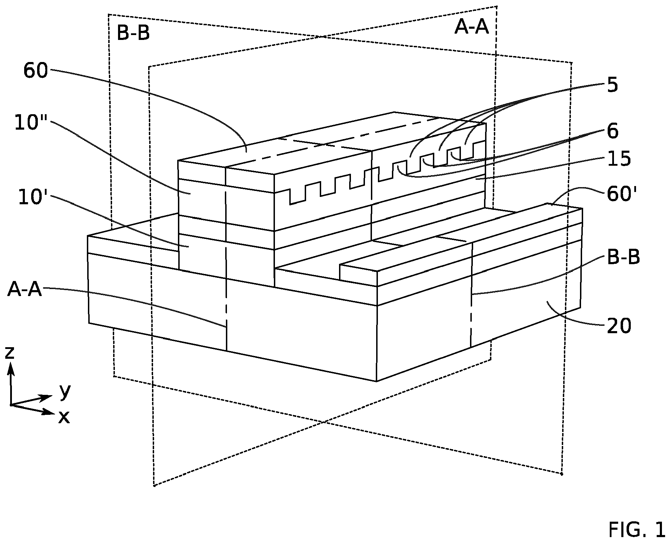

Un miroir de Bragg permet de réfléchir un rayonnement lumineux de longueur d'onde λ donnée avec une réflectivité R supérieure à 99%. Un tel miroir 65 comprend typiquement un réseau périodique de structures 5, 6 présentant des indices de réfraction différents (figure 1). Une réflexion partielle du rayonnement lumineux se produit à chaque alternance d'indices. Pour un pas de réseau de l'ordre de λ/2n, n étant l'indice de réfraction effectif, les réflexions partielles se combinent par interférences constructives, et les structures « distribuées » le long du réseau agissent comme un miroir de grande qualité. Un tel miroir est également appelé « réflecteur de Bragg distribué ».

Les miroirs de Bragg sont donc particulièrement avantageux pour la fabrication de cavités optiques pour des applications laser, et notamment pour la fabrication de lasers monomodes présentant une largeur spectrale très étroite.

Un laser comprenant un réflecteur de Bragg distribué est appelé laser à rétroaction répartie DFB (pour « Distributed FeedBack » signifiant « rétroaction distribuée » ou « rétroaction répartie »). Ce laser peut en outre être basé sur un principe d'amplification à cascade quantique. Un tel laser est alors dit LCQ (pour Laser à Cascade Quantique). Parmi les nombreuses applications des lasers LCQ DFB, la détection d'éléments chimiques ou biologiques ($CO_2$, $CH_4$, $NH_3$..., glucose ...) est particulièrement intéressante, dans la mesure où leur largeur spectrale très étroite permet d'augmenter avantageusement la sensibilité de détection.

Une architecture connue de laser LCQ DFB est présentée à la figure 1. Une telle architecture comprend typiquement une région active 15 bordée par des couches de guidage inférieures 10' et supérieures 10", et un miroir de Bragg 65 en partie supérieure. Le miroir de Bragg 65 est typiquement à base de métal, et peut également servir d'électrode 60 d'injection pour le pompage électrique du laser. La région active 15 et les couches de guidage 10', 10" peuvent être typiquement formées à partir d'une vignette à base de matériaux III-V, reportée sur un substrat silicium 20. Les couches de guidage 10', 10" permettent de confiner les modes optiques du rayonnement lumineux au sein de la région active 15, qui forme dès lors un guide d'onde pour la propagation du rayonnement lumineux selon y, tel qu'illustré à la figure 1. Cette approche combinant un miroir supérieur métallique et un guide d'onde permet de limiter les pertes optiques, par interaction entre les modes plasmoniques dus au métal et les modes propagatifs dans le guide d'onde.

En pratique, le miroir de Bragg peut être réalisé par corrugation de la partie supérieure des couches de guidage. Des tranchées sont ainsi formées transversalement au guide d'onde, et remplies de métal.

Le document « Volume Fabrication of Quantum Cascade Lasers on 200 mm-CMOS pilot line, Coutard et al., Scientific Reports | Nature research (2020) » divulgue un procédé de fabrication d'un tel miroir de Bragg métallique distribué en partie supérieure d'un LCQ. Après report d'une vignette en matériau III-V sur un substrat Si, un premier masque dur est formé sur les couches de guidage supérieures par lithographie UV, de façon à définir des motifs de miroir de Bragg distribué. Les couches de guidage supérieures sont ensuite gravées au travers de ces motifs, typiquement par gravure sèche anisotrope, de façon à former des tranchées. Un deuxième masque dur est ensuite formé sur le premier masque dur et dans les tranchées, de façon à définir un motif de ruban pour le laser. L'empilement des couches III-V est ensuite gravé de manière à former les parois du ruban laser. Le deuxième masque dur est ensuite retiré des tranchées. Les parois du ruban laser peuvent être passivées par une couche de passivation en laissant une ouverture d'accès aux tranchées. Les tranchées sont ensuite remplies de métal, et les contacts électriques sont formés.

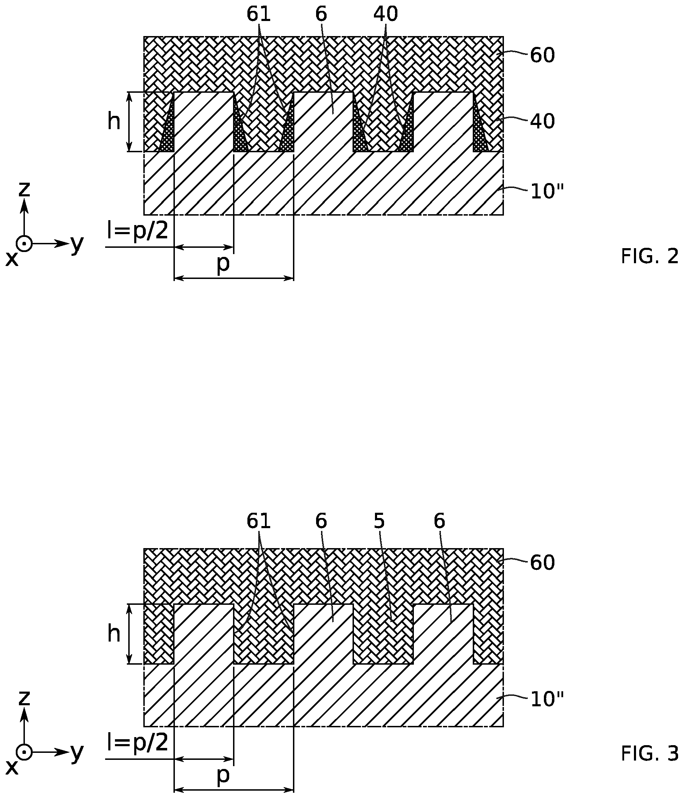

Une difficulté de ce procédé est la nécessité de retirer précautionneusement le masque dur des tranchées, avant remplissage métallique. Le nettoyage des tranchées n'est généralement pas parfait. Cela se traduit par la présence de résidus 40 de masque dur au fond des tranchées (figure 2). Ces résidus 40 engendrent alors un remplissage partiel du métal dans les tranchées du miroir de Bragg.

Un inconvénient de ce remplissage partiel est que la surface de contact entre le métal et les couches de guidage supérieures est dès lors diminuée. Dans l'exemple illustré à la figure 2, les résidus 40 se forment typiquement sur les parois 61 des corrugations 6. Ces résidus 40 diminuent d'environ 66% la surface de contact entre l'électrode 60 et les couches supérieures 10". La résistance de contact augmente proportionnellement. L'efficacité d'injection électrique est ainsi réduite. Les performances du LCQ sont dégradées.

Un autre inconvénient lié au remplissage partiel des tranchées par le métal est relatif au fonctionnement optique du miroir. En particulier, le taux de remplissage des tranchées du DFB est diminué par la présence des résidus. Cela modifie la bande passante du miroir ainsi que sa réflectivité. La largeur spectrale du rayonnement lumineux est ainsi augmentée. La précision sur la longueur d'onde d'émission diminue. Ainsi, une différence de longueur d'onde peut survenir entre un rayonnement lumineux émis par un laser DFB partiellement rempli et un laser DFB totalement rempli. Cette différence peut atteindre environ 8 nm. La reproductibilité des caractéristiques du laser est limitée.

Il existe donc un besoin consistant à dépasser les limitations des solutions connues.

En particulier, un objet de la présente invention est de proposer un procédé de réalisation permettant de remplir totalement les tranchées d'un miroir de Bragg métallique distribué.

## RESUME

Pour atteindre cet objectif, selon un mode de réalisation on prévoit un procédé de formation d'un miroir de Bragg distribué sur un laser à cascade quantique, comprenant :

- Une fourniture d'un empilement de couches à base de matériaux III-V comprenant au moins une région active destinée à émettre un rayonnement lumineux monochromatique,
- Un dépôt d'une première couche de masquage sur ledit empilement,
- Une formation de premiers motifs dans la première couche de masquage,
- Une formation de premières tranchées dans l'empilement, selon une première profondeur D1, à partir des premiers motifs de masquage, lesdites premières tranchées s'étendant principalement selon une première direction x et étant destinées à former des motifs du miroir de Bragg distribué,
- Un dépôt d'une deuxième couche de masquage au moins dans les premières tranchées,
- Une formation de deuxièmes motifs dans la deuxième couche de masquage, de part et d'autre des premiers motifs,
- Une formation de deuxièmes tranchées dans l'empilement, selon une deuxième profondeur D2 supérieure à la première profondeur D1, à partir des deuxièmes motifs de masquage, lesdites deuxièmes tranchées s'étendant selon une deuxième direction y perpendiculaire à la première direction x et étant destinées à former des parois du laser à cascade quantique,
- Un retrait de la deuxième couche de masquage dans les premières tranchées,
- Un remplissage desdites premières tranchées par au moins un matériau métallique.

Avantageusement, le procédé comprend en outre :

- Avant dépôt de la deuxième couche de masquage, une formation d'une couche intercalaire sacrificielle au moins dans les premières tranchées, et
- Avant remplissage desdites premières tranchées par l'au moins un matériau métallique et après retrait de la deuxième couche de masquage dans les premières tranchées, un retrait de ladite couche intercalaire sacrificielle.

Avantageusement, ce retrait de ladite couche intercalaire sacrificielle permet de retirer par décollement des résidus de la deuxième couche de masquage restant dans les premières tranchées à l'issue de l'étape de retrait de la deuxième couche de masquage dans les premières tranchées.

Ainsi, le procédé permet de nettoyer complètement les premières tranchées avant le remplissage métallique. Les résidus de la deuxième couche de masquage, qui sont difficilement dissous par les solutions connues de nettoyage des tranchées, sont ici avantageusement éliminés en les désolidarisant des parois et/ou du fond des premières tranchées, par une technique de décollement dite lift off. Il n'est donc pas nécessaire de graver ou dissoudre les résidus. Le retrait de la couche intercalaire sacrificielle permet de décoller les résidus, qui sont ensuite facilement éliminés, par exemple de façon mécanique grâce au flux de la solution de gravure utilisée pour le retrait de la couche intercalaire sacrificielle.

Comme illustré à la figure 3, les parois 61 des corrugations 6 sont dès lors accessibles au métal lors du dépôt métallique. Le procédé peut ainsi permettre d'augmenter la surface de contact entre le métal d'une part, et les corrugations et les couches de guidage supérieures d'autre part, de 66% environ. Cela permet d'assurer une bonne injection électrique pour l'émission laser.

Le facteur de forme des structures métalliques 5 est amélioré. Le taux de remplissage des structures 5, 6 du miroir de Bragg est ainsi amélioré. La variabilité en largeur spectrale du miroir de Bragg est significativement diminuée. Cela permet d'assurer une bonne reproductibilité spectrale de l'émission laser.

L'utilisation de la couche intercalaire sacrificielle en conjonction avec la deuxième couche de masquage permet ainsi d'optimiser le remplissage du métal dans le réseau des premières tranchées. La maîtrise du procédé de fabrication du miroir de Bragg d'un laser DFB est ainsi améliorée. La mise en oeuvre du procédé est d'autant plus avantageuse que la hauteur h des corrugations est importante, et/ou que le facteur de forme p/(2.h) des corrugations est petit, typiquement inférieur à 1, p étant le pas du réseau de Bragg.

Le procédé permet donc de réaliser des lasers DFB présentant des performances améliorées. Le procédé est en outre typiquement basé sur une filière technologique silicium compatible avec une chaine de fabrication dite CMOS (fabrication de transistors métal-oxyde-semiconducteur complémentaires).

## BREVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

La figure 1 illustre schématiquement un laser DFB comprenant un miroir de Bragg métallique en partie supérieure.

La figure 2 illustre schématiquement en coupe longitudinale des résidus entre les corrugations d'un miroir de Bragg formé par un procédé selon l'art antérieur.

La figure 3 illustre schématiquement en coupe longitudinale des corrugations - exemptes de résidus - d'un miroir de Bragg formé par le procédé selon un mode de réalisation de la présente invention.

Les figures 4A, 5A, 6A, 7A, 8A, 9A, 10A illustrent schématiquement en coupe longitudinale selon le plan AA' illustré à la figure 1, des étapes de fabrication d'un laser DFB selon un mode de réalisation de la présente invention.

Les figures 4B, 5B, 6B, 7B, 8B, 9B, 10B illustrent schématiquement en coupe transverse selon le plan BB' illustré à la figure 1, les étapes de fabrication d'un laser DFB selon un mode de réalisation de la présente invention, en correspondance avec les étapes illustrées aux figures 4A, 5A, 6A, 7A, 8A, 9A, 10A.

La figure 11 illustre schématiquement en coupe longitudinale un empilement comprenant une couche d'arrêt pour la gravure des premières tranchées, selon un mode de réalisation du procédé de fabrication du miroir de Bragg de la présente invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, sur les schémas de principe, les épaisseurs des différentes couches, et les dimensions des motifs ne sont pas représentatives de la réalité.

## DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple, la couche intercalaire sacrificielle est à base d'oxyde de silicium et la deuxième couche de masquage est à base de nitrure de silicium. Ces deux matériaux présentent une bonne sélectivité de gravure, typiquement pour une gravure humide à base d'acide fluorhydrique. Cela facilite le retrait par lift off. Ces matériaux sont en outre compatibles avec la technologie CMOS.

Selon un exemple, la couche intercalaire sacrificielle présente une épaisseur e sensiblement constante et comprise entre 100 nm et 300 nm. Elle peut être typiquement formée par dépôt conforme. Une épaisseur constante permet un meilleur contrôle du procédé de lift off.

Selon un exemple, la formation des premières tranchées se fait par gravure anisotrope selon une troisième direction z normale aux première et deuxième directions x, y.

Selon un exemple, le retrait de la couche intercalaire sacrificielle se fait par gravure humide à partir d'une solution tamponnée à base d'acide fluorhydrique. Cela permet d'avoir une bonne sélectivité de gravure dans le cas d'une couche intercalaire sacrificielle à base d'oxyde de silicium et d'une deuxième couche de masquage à base de nitrure de silicium. Une solution tamponnée permet également d'améliorer le contrôle du retrait lors du lift off.

Selon un exemple, l'empilement comprend une couche d'arrêt pour la formation par gravure des premières tranchées, ladite couche d'arrêt étant située à une profondeur sensiblement égale à D1 par rapport à une face supérieure de l'empilement. Une détection de fin d'attaque permet typiquement de surveiller quand est atteinte la couche d'arrêt lors de la gravure des tranchées. Cela permet dès lors d'arrêter la gravure lorsque la profondeur D1 est atteinte, en réduisant significativement voire en éliminant l'incertitude sur cette profondeur de gravure. Cela est d'autant plus avantageux que la profondeur D1 visée est grande, typiquement pour $D1 \geq 1,5$ $\lambda/4n_{eff}$, avec $\lambda$ une longueur d'onde du rayonnement lumineux monochromatique et $n_{eff}$ un indice effectif.

Selon un exemple, la couche d'arrêt est à base d'InGaAs et présente une épaisseur e' comprise entre 20 nm et 200 nm. Une couche d'arrêt à base d'InGaAs présente typiquement un indice de réfraction suffisamment bas pour des applications laser. Elle est de préférence dopée, de manière à permettre le transfert des porteurs lors du fonctionnement du laser. L'épaisseur e' est de préférence inférieure à une épaisseur critique définissant un domaine de relaxation plastique. Cela permet d'obtenir une couche d'arrêt de nature cristalline.

Selon un exemple, la profondeur D1 est choisie telle que D1 soit environ égale à $\lambda/4n_{eff}$, avec $\lambda$ une longueur d'onde du rayonnement lumineux monochromatique et $n_{eff}$ un indice effectif.

Selon un exemple, la profondeur D1 est choisie telle que D1 soit comprise entre $0,5 \ \lambda/4n_{eff}$ et $1,5 \ \lambda/4n_{eff}$, avec $\lambda$ une longueur d'onde du rayonnement lumineux monochromatique et $n_{eff}$ un indice effectif.

Selon un exemple, la profondeur D1 est choisie telle que D1 soit supérieure à $1,5 \ \lambda/4n_{eff}$, avec $\lambda$ une longueur d'onde du rayonnement lumineux monochromatique et $n_{eff}$ un indice effectif.

Selon un exemple, les premières tranchées sont distribuées selon un réseau de pas p environ égal à $\lambda/2n_{eff}$, avec $\lambda$ une longueur d'onde du rayonnement lumineux monochromatique et $n_{eff}$ un indice effectif.

Selon un exemple, les premières tranchées présentent une largeur p/2 et un facteur de forme $\varphi$ = p/(2.D1). Une largeur p/2 correspond à un taux de remplissage des DFB de 50%, p étant le pas du réseau de Bragg distribué.

Selon un exemple, le facteur de forme $\varphi$ est supérieur ou égal à 0,8.

Selon un exemple, le facteur de forme $\varphi$ est inférieur ou égal à 1,1.

Selon un exemple, le procédé comprend en outre, après formation des deuxièmes tranchées, une formation d'une couche de passivation sur les parois du laser à cascade quantique.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage indiqués dans la présente demande sont les suivantes :

- dopage p++ ou n++ : supérieur à $1 \times 10^{20}$ cm$^{-3}$
- dopage p+ ou n+ : $1 \times 10^{18}$ cm$^{-3}$ à $9 \times 10^{19}$ cm$^{-3}$
- dopage p ou n : $1 \times 10^{17}$ cm$^{-3}$ à $1 \times 10^{18}$ cm$^{-3}$
- dopage intrinsèque : $1.10^{15}$ cm$^{-3}$ à $1.10^{17}$ cm$^{-3}$

Le domaine du moyen infrarouge (MIR) comprend typiquement des longueurs d'onde $\lambda$ entre 3 $\mu$m et 12 $\mu$m. Un exemple de mise en oeuvre du procédé est donné pour la réalisation d'un laser QCL DFB émettant à une longueur d'onde de 7,4 $\mu$m.

Plusieurs modes de réalisation de l'invention mettant en oeuvre des étapes successives du procédé de fabrication sont décrits ci-après. Sauf mention explicite, l'adjectif « successif » n'implique pas nécessairement, même si cela est généralement préféré, que les étapes se suivent immédiatement, des étapes intermédiaires pouvant les séparer.

Par ailleurs, le terme « étape » s'entend de la réalisation d'une partie du procédé, et peut désigner un ensemble de sous-étapes.

Par ailleurs, le terme « étape » ne signifie pas obligatoirement que les actions menées durant une étape soient simultanées ou immédiatement successives. Certaines actions d'une première étape peuvent notamment être suivies d'actions liées à une étape différente, et d'autres actions de la première étape peuvent être reprises ensuite. Ainsi, le terme étape ne s'entend pas forcément d'actions unitaires et inséparables dans le temps et dans l'enchaînement des phases du procédé.

Un principe de fonctionnement du laser à cascade quantique est le suivant : la région active est polarisée électriquement de façon à injecter des électrons. Cette région active comprend une multitude de puits quantiques dans lesquels un électron va perdre successivement une partie de son énergie, en cascade, en émettant à chaque fois un photon d'énergie donnée. Ces photons forment le rayonnement lumineux de longueur d'onde $\lambda$.

Ce rayonnement lumineux se propage de façon guidée au sein d'une cavité optique. Cette cavité optique est typiquement bornée par des couches inférieures et supérieures dites LOC (acronyme de « Low Optical Confinement » signifiant faible confinement optique), et au moins un miroir de Bragg.

Le miroir de Bragg de la cavité optique présente typiquement un pic de réflectivité centré sur la longueur d'onde $\lambda$.

Ce pic de réflectivité présente une certaine largeur spectrale $\delta\omega_{DBR}$.

Cette largeur spectrale $\delta\omega_{DBR}$ (en nm) dépend notamment du facteur de corrugation $\kappa$ du réseau de Bragg, également dénommé force du réseau, et de la longueur du réseau de Bragg $L_g$ :

$$\delta\omega_{DBR} = \frac{\pi}{v_g \sqrt{|\kappa|^2 + \left(\frac{\pi}{L_g}\right)^2}}$$

Où $v_g$ est la vitesse de groupe du rayonnement lumineux.

Le facteur de corrugation $\kappa$ peut s'exprimer selon :

$$\kappa = \frac{\pi.n_{eff}}{\lambda} \frac{\int\int_\Omega n_{inf}^2 n_{sup}^2 E^2 dxdy}{\iint E^2 dxdy}$$

Où $\Omega$ est la section du mode optique se propageant dans le guide d'onde, $n_{inf}$ et $n_{sup}$ sont respectivement les indices de réfraction des structures ou corrugations alternées 5, 6 du réseau de Bragg comme illustré aux figures 1 et 3, $n_{eff}$ est un indice effectif du réseau (moyenne pondérée des indices liés aux corrugations 5, 6) et E est le champ électrique du rayonnement lumineux en dehors de la région perturbée par les corrugations.

Dans le cadre de la présente invention, les locutions « miroir de Bragg », « réseau de Bragg » ou « réflecteur de Bragg distribué » ou encore « DFB (Distributed FeedBack) » sont employées en synonymes. Le miroir de Bragg est ici configuré pour être utilisé comme réflecteur dans un guide d'onde ou dans une cavité optique. Il comprend une alternance de matériaux d'indices de réfraction différents. Cette alternance est reproduite au moins deux fois dans le cadre d'un miroir de Bragg selon la présente invention.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy.

Un élément situé « à l'aplomb » ou « au droit d'» un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

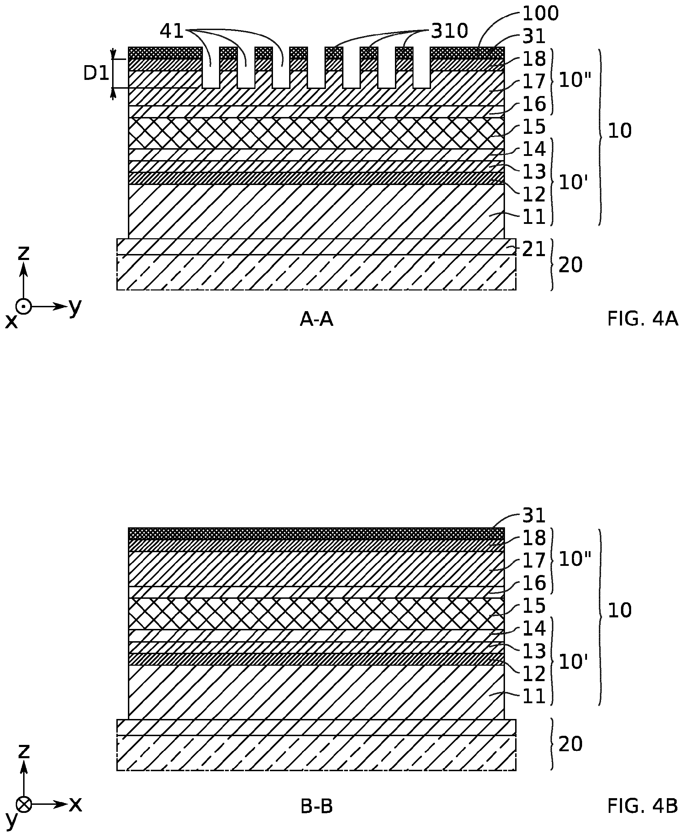

Un exemple de mise en oeuvre du procédé est illustré aux figures 4A à 10B. Dans cet exemple, une vignette comprenant un empilement 10 de couches à base de matériaux III-V est d'abord collée sur un substrat 20, par exemple à base de silicium. Ce collage peut typiquement se faire par collage moléculaire, par exemple par l'intermédiaire de couches 21 oxyde sur oxyde ou InP sur oxyde.

La vignette peut se présenter sous forme d'un substrat InP de deux pouces sur lequel est formé l'empilement 10.

L'empilement 10 comprend typiquement une pluralité de couches 11, 12, 13, 14, 15, 16, 17, 18 destinées à l'injection des électrons, à l'émission du rayonnement lumineux, au guidage du rayonnement lumineux.

Selon une possibilité, l'empilement 10 peut comprendre, depuis la couche de collage 21 jusqu'à la surface 100 de l'empilement selon z :

- une couche 11 à base d'InP dopée n++, présentant une épaisseur comprise entre 1,5 $\mu$m et 5 $\mu$m,
- une couche 12 à base d'InGaAs dopée n++, présentant une épaisseur comprise entre 100 nm et 200 nm,
- une couche 13 à base d'InP, présentant une épaisseur comprise entre 100 nm et 200 nm,

- une couche 14 à base d'InGaAs dite LOC, présentant une épaisseur comprise entre 20 nm et 200 nm,
- une région active 15 présentant une épaisseur comprise entre 1,5 $\mu$m et 5 $\mu$m,
- une couche 16 à base d'InGaAs dite LOC, présentant une épaisseur comprise entre 20 nm et 200 nm,
- une couche 17 à base d'InP, présentant une épaisseur comprise entre 1 $\mu$m et 3 $\mu$m,
- une couche 18 à base d'InGaAs dopée n++, présentant une épaisseur comprise entre 20 nm et 200 nm.

Les couches 11, 12, 18 dopées n++ participent typiquement à l'injection des électrons au sein de la région active 15. Les couches 14, 16 LOC permettent typiquement de confiner le rayonnement lumineux au niveau de la région active 15. Elles présentent typiquement un faible indice de réfraction, par exemple de l'ordre de 3,17 pour une longueur d'onde $\lambda$ de l'ordre de 7,4 $\mu$m, et sont appelées couches de guidage. La couche d'InP 17 est en partie destinée à être structurée de façon à former un miroir DFB.

La région active 15 comprend typiquement une multitude de puits quantiques dans lesquels les électrons vont transiter en cascade, en émettant un rayonnement lumineux. Selon une possibilité, la région active 15 peut comprendre des couches d'InGaAs et d'AlInAs alternées. Le lecteur peut se référer au document « Carras, M. et al. Top grating index-coupled distributed feedback quantum cascade lasers. Appl. Phys. Lett. 93, 011109 (2008) » pour la conception de la région active, en particulier pour le choix des hétérostructures d'InGaAs/d'AlInAs, le nombre de périodes et/ou de puits quantiques, l'architecture de super-réseau résonnant.

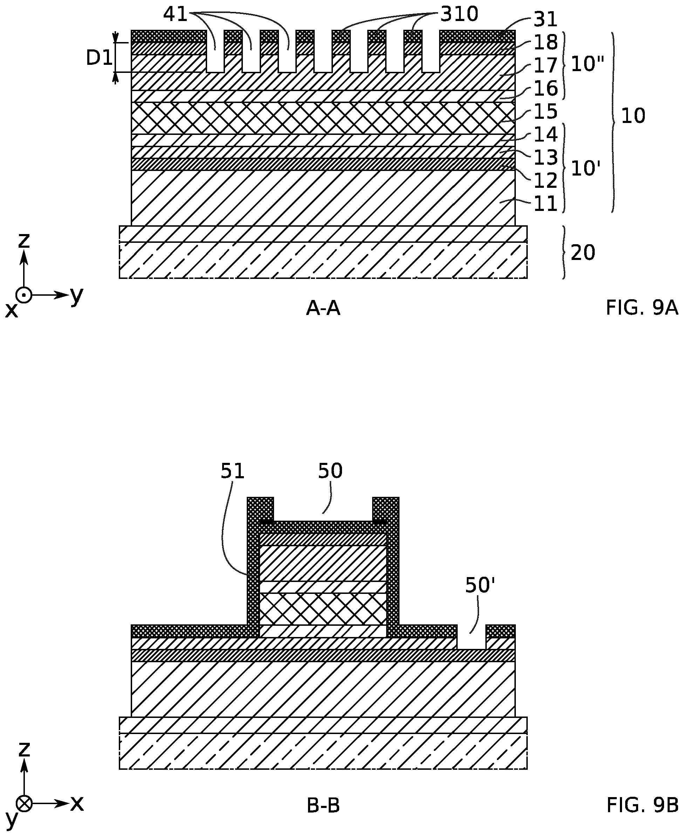

Après fourniture de l'empilement 10 (figures 9A, 9B), une couche de masquage 31 est formée sur la surface 100 de l'empilement 10. Cette couche de masquage 31 peut être déposée de façon conforme par dépôt chimique en phase vapeur assisté par plasma PECVD (acronyme de Plasma Enhanced Chemical Vapor Déposition). Elle est de préférence à base de SiN. Cette couche de masquage 31 est destinée à former un masque dur pour la gravure ultérieure des tranchées 41 du miroir de Bragg. Elle peut être ainsi structurée par photolithographie et gravure, de façon à former des motifs 310. Alternativement, la couche de masquage 31 est directement à base d'une résine de photolithographie.

La couche de masquage 31 présente typiquement une épaisseur d'environ 100 nm. Cette épaisseur de couche de masquage 31 est de préférence suffisamment fine de façon à former des motifs 310 bien résolus et bien définis.

Les motifs 310 forment typiquement un réseau de lignes dont le pas p est de l'ordre de quelques centaines de nanomètres, par exemple 1165 nm pour un rayonnement de longueur d'onde $\lambda$ = 7,4 $\mu$m. Selon une possibilité préférée, le pas du réseau p est choisi de sorte que p = $\lambda/2n_{eff}$.

Des tranchées 41 sont ensuite gravées entre les lignes du réseau, sur une profondeur D1. Cette gravure peut se faire par gravure sèche anisotrope selon z, par exemple par plasma à couplage inductif ICP (Inductively Coupled Plasma). La profondeur D1 est de préférence choisie de sorte que $D1 = \lambda/4n_{eff}$. Selon une possibilité connue du document US 7567606 B2, la profondeur D1 peut être choisie de sorte que D1 soit comprise entre $0,5\ \lambda/4n_{eff}$ et $1,5\ \lambda/4n_{eff}$. Par exemple, pour un rayonnement de longueur d'onde $\lambda = 7,4\ \mu m$, la profondeur D1 est de préférence comprise entre 300 nm et 900 nm.

La force du réseau DFB $\kappa$ varie peu dans cette gamme de profondeur de gravure D1. La réflectivité du DFB est donc sensiblement constante. Les performances du laser comprenant un tel miroir DFB sont stables et dépendent peu des variations de profondeur de gravure liées au procédé.

Les tranchées 41 traversent typiquement la couche 18 d'InGaAs pour s'étendre jusque dans la couche 17 d'InP. Elles présentent une largeur l selon y et un facteur de forme $\varphi = l/D1$. Selon une possibilité préférée, la largeur l est égale à p/2. Le facteur de forme $\varphi$ peut être compris entre 0,8 et 1,1. De façon avantageuse, le facteur de forme $\varphi$ peut être inférieur à 0,8. Un facteur de forme inférieur à 1 correspond typiquement à des tranchées profondes. Un DFB comprenant des tranchées profondes présente une force de réseau augmentée. Le DFB est ainsi plus efficace et offre un meilleur couplage entre les modes propagatif et contre-propagatif. La réflexion du réseau DFB est accrue. Cela permet notamment de concevoir une cavité laser plus courte.

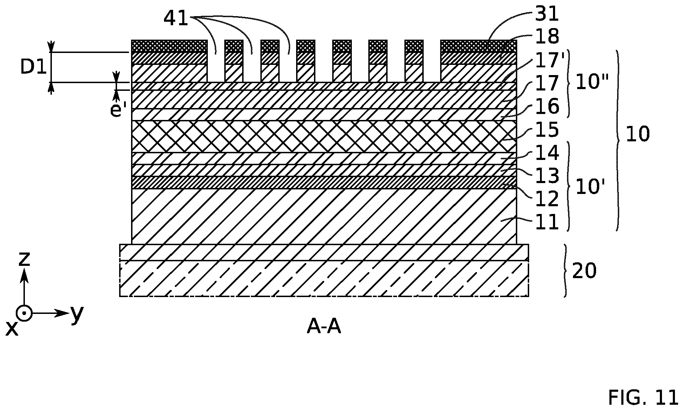

Selon une variante optionnelle illustrée à la figure 11, une couche d'arrêt 17' de gravure est prévue dans l'empilement 10, typiquement au sein de la couche 17 d'InP. Cette couche d'arrêt 17' est destinée à contrôler précisément l'arrêt de la gravure lors de la gravure des tranchées 41. Elle peut être située dans l'empilement 10 à la profondeur D1 par rapport à la surface 100. Avantageusement, la couche d'arrêt 17' est mise en oeuvre pour des applications nécessitant une profondeur $D1 \geq 1,5\ \lambda/4n_{eff}$, c'est-à-dire dans une gamme de profondeurs en dehors du domaine de stabilité du facteur de corrugation x. Une profondeur $D1 \geq 1,5\ \lambda/4n_{eff}$ permet par exemple de diminuer la longueur de la cavité du laser DFB. La couche d'arrêt 17' permet dès lors d'obtenir une bonne reproductibilité de la hauteur des corrugations 6 du miroir DFB. La reproductibilité du procédé de fabrication du miroir DFB est améliorée. Un contrôle précis de la profondeur des tranchées permet en outre de définir précisément la longueur d'onde du rayonnement lumineux.

La couche d'arrêt 17' peut être à base d'InGaAs. Elle présente une épaisseur e' de l'ordre de quelques nanomètres à quelques centaines de nanomètres. Elle est de préférence dopée, de manière à permettre le transfert des porteurs lors du fonctionnement du laser. L'épaisseur e' est de préférence inférieure à une épaisseur critique définissant un domaine de relaxation plastique. Cela permet d'obtenir une couche d'arrêt pseudo-morphique. Cette couche d'arrêt 17' est par exemple similaire aux couches LOC InGaAs bas indice d'épaisseurs comprises entre 20 nm et 200 nm. Cela permet d'améliorer le confinement du mode optique de propagation du rayonnement lumineux. Une couche d'arrêt à base d'InGaAs présente typiquement un indice de réfraction suffisamment bas pour des applications laser. Cela permet de mieux confiner le mode optique de propagation du rayonnement lumineux.

Selon une possibilité, la gravure des tranchées dans l'InP se fait par gravure humide à base de HCL. Une telle solution présente une bonne sélectivité de gravure entre l'InP et l'InGaAs. Cela permet de graver sélectivement l'InP avec arrêt sur la couche d'arrêt 17' LOC InGaAs.

Selon une autre possibilité, la gravure des tranchées dans l'InP se fait par gravure sèche, typiquement si le taux d'ouverture des motifs 310 du réseau est supérieur à 10 %. Lors de la gravure des tranchées 41, les produits de gravure volatils peuvent être analysés en temps réel par spectroscopie. Lorsque la gravure atteint la couche d'arrêt 17', la nature des produits de gravure change. Ce changement est détecté par spectroscopie et la gravure est arrêtée. La couche 17' est ainsi avantageusement utilisée pour la détection de fin de gravure encore appelée détection de fin d'attaque (DFA).

La suite du procédé peut s'appliquer indifféremment aux deux variantes - avec ou sans couche d'arrêt de gravure dans l'empilement - décrites précédemment.

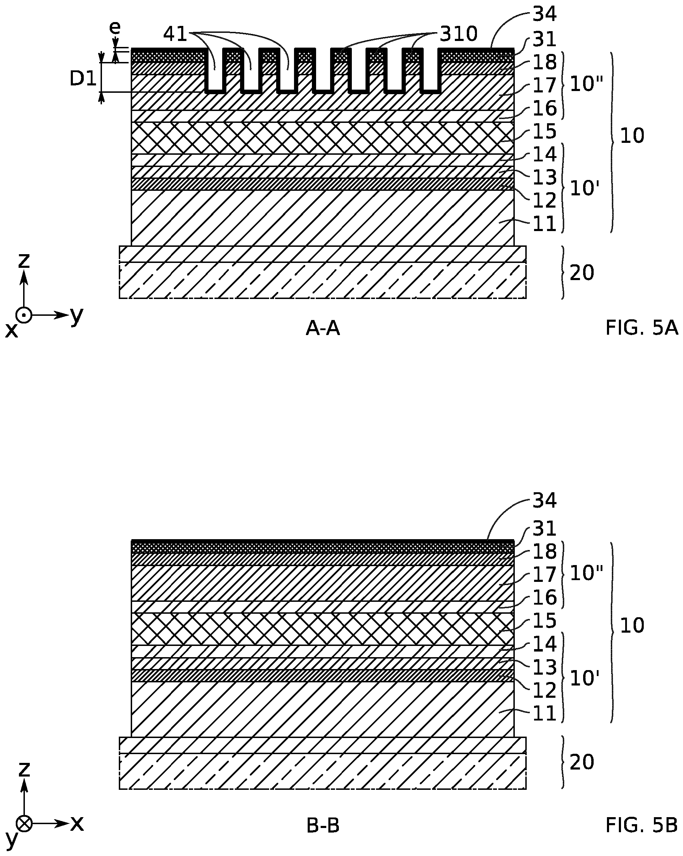

Après formation des motifs 310 et des tranchées 41, une couche intercalaire sacrificielle 34 est formée dans les tranchées 41 (figures 5A, 5B). Cette couche intercalaire sacrificielle 34 est de préférence déposée de façon conforme par dépôt chimique en phase vapeur assisté par plasma PECVD (acronyme de Plasma Enhanced Chemical Vapor Déposition). Selon une autre possibilité, elle peut être déposée par dépôt sous faisceau d'ions IBD (Ion Beam Déposition) ou par dépôt de couches minces atomiques ALD (Atomic Layer Déposition). La couche intercalaire sacrificielle 34 peut être à base d'oxyde de silicium. Elle présente une épaisseur e de l'ordre de quelques nanomètres à quelques centaines de nanomètres. L'épaisseur e de la couche intercalaire sacrificielle 34 est par exemple comprise entre 100 nm et 300 nm.

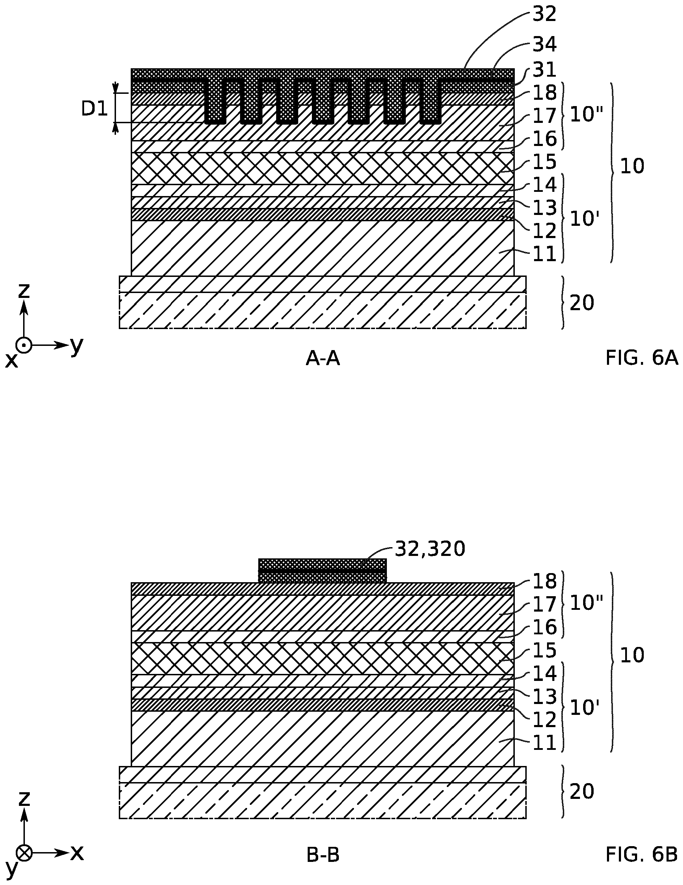

Après formation de la couche intercalaire sacrificielle 34, une deuxième couche de masquage 32 est formée sur la couche intercalaire sacrificielle 34 et dans les tranchées 41 (figures 6A, 6B). Cette couche de masquage 32 peut être déposée de façon conforme par dépôt chimique en phase vapeur assisté par plasma PECVD (acronyme de Plasma Enhanced Chemical Vapor Déposition). Elle est de préférence à base de SiN. Cette couche de masquage 32 est destinée à former un masque dur pour la gravure ultérieure du motif de ruban du laser. Elle peut être ainsi structurée par photolithographie et gravure, de façon à former un ou des motifs 320, au moins sur le réseau de tranchées 41 du miroir DFB.

La couche de masquage 32 présente typiquement une épaisseur comprise entre 400 nm et 600 nm, en fonction de la profondeur à graver lors de la gravure du motif de ruban du laser. Une telle épaisseur de couche de masquage 32 permet de protéger les tranchées et l'empilement sous-jacent, lors de la gravure du motif de ruban du laser.

Le motif 320 forme typiquement un rectangle couvrant le réseau de tranchées 41, dont les grands côtés s'étendent selon y, de part et d'autres des tranchées 41, sur une distance définissant la longueur de cavité du laser. Cette longueur de cavité peut atteindre plusieurs millimètres, par exemple 4 mm. Les petits côtés de ce motif 320 rectangulaire s'étendent selon x sur une distance définissant la largeur de cavité du laser. Cette largeur de cavité peut être de l'ordre de quelques microns à quelques dizaines de microns, par exemple de l'ordre de 8 $\mu$m ou 10 $\mu$m. Elle peut être supérieure ou égale à la dimension des tranchées selon x.

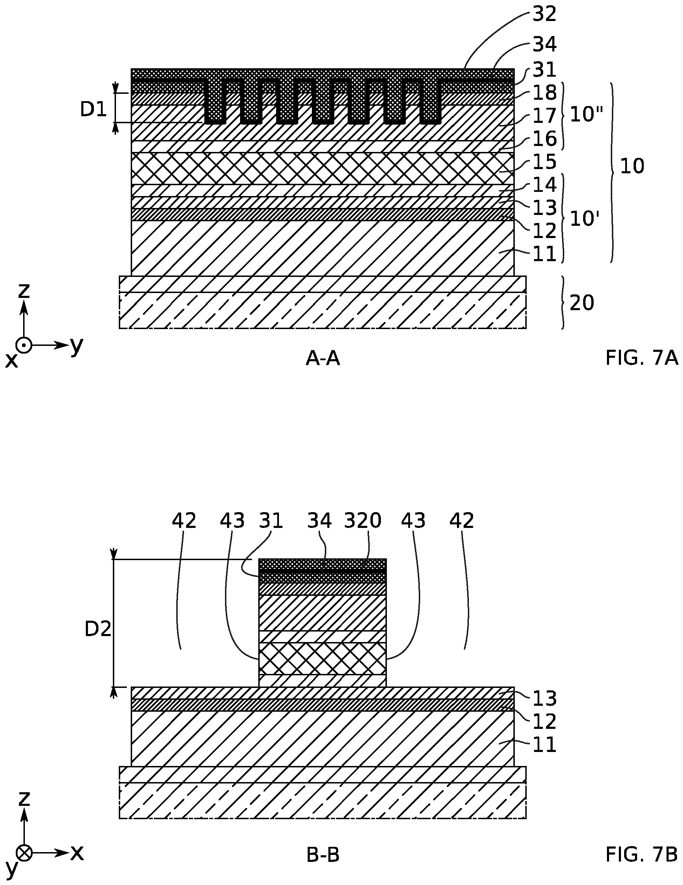

Des tranchées 42 sont ensuite gravées de part et d'autre du motif 320, sur une profondeur D2 (figures 7A, 7B). Cette gravure peut se faire par gravure sèche anisotrope selon z, par exemple par plasma à couplage inductif ICP (Inductively Coupled Plasma). La gravure est de préférence configurée pour être arrêtée dans la couche 13 d'InP. Cette gravure permet de former un ruban comprenant la région active 15 dans l'empilement 10 de matériaux III-V. Ce ruban forme un guide d'onde pour le rayonnement lumineux.

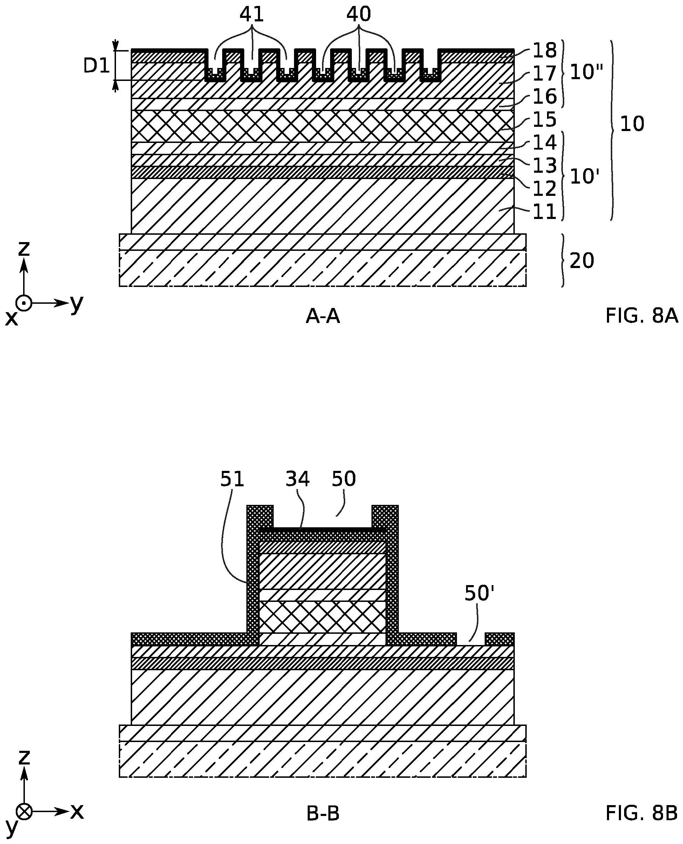

Les parois 43 du ruban sont ensuite passivées de préférence par dépôt d'une couche de passivation 51 en SiN, par exemple d'épaisseur comprise entre 400 nm et 900 nm (figures 8A, 8B). Des ouvertures 50, 50' sont formées dans la couche de passivation 51, par exemple par gravure plasma RIE (acronyme de Reactive Ion Etching), de façon à définir une zone de contact supérieure au niveau des tranchées 41, et une zone de contact inférieure au niveau de la couche 13 d'InP.

A ce stade, des résidus 40 en SiN sont généralement présents au fond des tranchées 41 (figure 8A).

Ces résidus 40 sont avantageusement retirés par lift off lors de la gravure de la couche intercalaire sacrificielle 34 (figures 9A, 9B). Cette gravure se fait de préférence par voie humide, à partir d'une solution dite BOE (acronyme de « Buffer Oxyde Etch » signifiant gravure tamponnée d'oxyde). Une telle solution BOE peut être avantageusement utilisée pour graver une couche mince de dioxyde de silicium SiO2, telle que la couche intercalaire sacrificielle 34. Cette solution est typiquement composée d'un tampon, comme du fluorure d'ammonium NH4F, et d'acide fluorhydrique HF. Cela permet de rendre l'acide fluorhydrique un peu moins réactif et donc d'avoir un meilleur contrôle sur la réaction de gravure. Un ratio 7:1 entre le fluorure d'ammonium et l'acide fluorhydrique peut par exemple être utilisé.

Un tel retrait de la couche intercalaire sacrificielle 34 est sélectif vis-à-vis du SiN des résidus 40. Il permet ainsi de décoller les résidus 40. Ces derniers sont ensuite évacués sans être totalement dissous, par exemple par le flux de la solution de gravure BOE ou lors du rinçage consécutif à cette gravure.

La couche 13 d'InP peut être gravée par gravure chimique ou gravure plasma avec arrêt sur la couche 12 d'InGaAs, avant formation des contacts électriques (figure 9B). Selon une autre possibilité la couche 12 peut être à base d'InAlAs dopé. Cela permet également une bonne sélectivité de gravure vis-à-vis de l'InP.

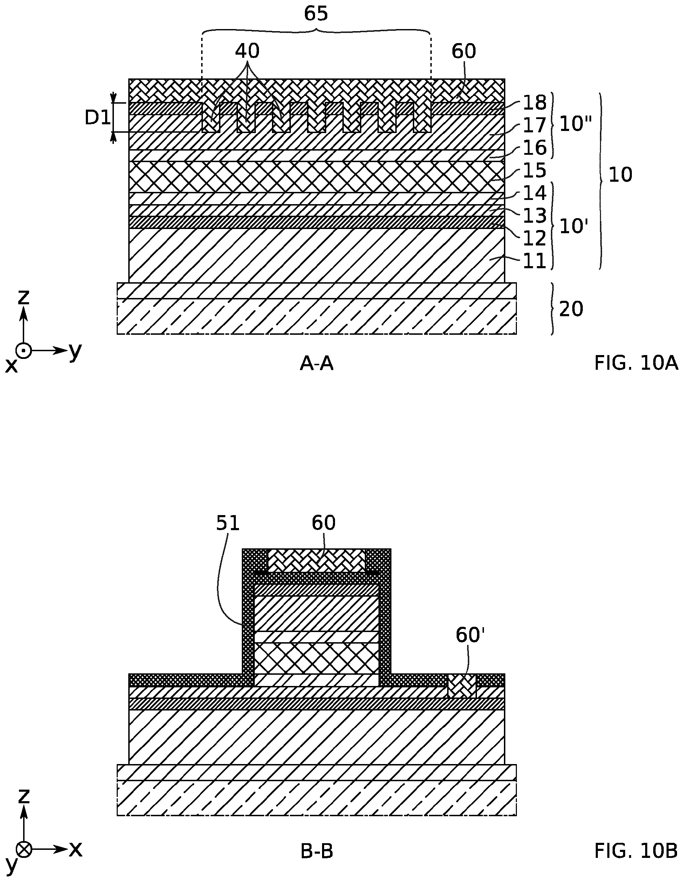

A l'issue du retrait de la couche intercalaire sacrificielle 34, les tranchées 41 sont avantageusement exemptes de résidus. Elles peuvent ainsi être totalement remplies de métal lors du dépôt métallique suivant (figures 10A, 10B). Ce dépôt métallique peut typiquement se présenter sous forme d'un empilement de couches métalliques à base de Ti/TiN/Au. L'empilement de couches métalliques peut présenter une épaisseur comprise entre 1 $\mu$m et 3 $\mu$m. La structuration de ce dépôt métallique par photolithographie / gravure permet de définir et former le miroir de Bragg DFB 65 et les électrodes 60, 60'.

Au vu de la description qui précède, il apparaît clairement que le procédé proposé offre une solution particulièrement efficace pour réaliser des miroirs de Bragg métal/InP sur une filière InP compatible avec les technologies CMOS. Le procédé de fabrication du DFB est en outre simplifié. Le miroir DFB ainsi formé est particulièrement efficace à la fois optiquement, grâce au fort contraste d'indice InP/métal, et à la fois électriquement, du fait de sa fonction d'électrode d'injection électrique.

L'invention n'est pas limitée aux modes de réalisations précédemment décrits et s'étend à tous les modes de réalisation couverts par les revendications.

Les lasers LCQ DFB réalisés par ce procédé peuvent notamment présenter d'autres architectures, par exemple selon une configuration dite à double tranchée. Une telle configuration permet notamment d'obtenir une surface plane plus étendue lors des étapes ultérieures de soudure et de conditionnement.

**Revendications**

1. Procédé de formation d'un miroir de Bragg (65) distribué sur un laser à cascade quantique, comprenant :

   - Une fourniture d'un empilement (10) de couches (11, 12, 13, 14, 15, 16, 17, 17', 18) à base de matériaux III-V comprenant au moins une région active (15) destinée à émettre un rayonnement lumineux monochromatique,
   - Un dépôt d'une première couche (31) de masquage sur ledit empilement (10),
   - Une formation de premiers motifs (310) dans la première couche (31) de masquage,
   - Une formation de premières tranchées (41) dans l'empilement (10), selon une première profondeur D1, à partir des premiers motifs (310) de masquage, lesdites premières tranchées (41) s'étendant principalement selon une première direction (x) et étant destinées à former des structures (5) du miroir de Bragg (65) distribué,

- Un dépôt d'une deuxième couche (32) de masquage au moins dans les premières tranchées (41),

- Une formation de deuxièmes motifs (320) dans la deuxième couche (32) de masquage, de part et d'autre des premiers motifs (310),

- Une formation de deuxièmes tranchées (42) dans l'empilement (10), selon une deuxième profondeur D2 supérieur à la première profondeur D1, à partir des deuxièmes motifs (320) de masquage, lesdites deuxièmes tranchées (42) s'étendant principalement selon une deuxième direction (y) perpendiculaire à la première direction (x) et étant destinées à former des parois (43) du laser à cascade quantique,

- Un retrait de la deuxième couche (32) de masquage dans les premières tranchées (41),

- Un remplissage desdites premières tranchées (41) par au moins un matériau métallique,

Ledit procédé étant **caractérisé en ce qu'**il comprend en outre :

- Avant dépôt de la deuxième couche (32) de masquage, une formation d'une couche (34) intercalaire sacrificielle au moins dans les premières tranchées (41), et

- Avant remplissage desdites premières tranchées (41) par l'au moins un matériau métallique et après retrait de la deuxième couche (32) de masquage dans les premières tranchées (41), un retrait de ladite couche (34) intercalaire sacrificielle de façon à retirer par décollement des résidus (40) de la deuxième couche (32) de masquage restant dans les premières tranchées (41) à l'issue de l'étape de retrait de la deuxième couche (32) de masquage dans les premières tranchées (41).

2. Procédé selon la revendication précédente dans lequel la couche (34) intercalaire sacrificielle est à base d'oxyde de silicium.

3. Procédé selon l'une quelconque des revendications précédentes dans lequel la deuxième couche (32) de masquage est à base de nitrure de silicium.

4. Procédé selon l'une quelconque des revendications précédentes dans lequel la couche (34) intercalaire sacrificielle présente une épaisseur e sensiblement constante et comprise entre 100 nm et 300 nm.

5. Procédé selon l'une quelconque des revendications précédentes dans lequel le retrait de la couche (34) intercalaire sacrificielle se fait par gravure humide à partir d'une solution tamponnée à base d'acide fluorhydrique.

6. Procédé selon l'une quelconque des revendications précédentes dans lequel l'empilement (10) comprend une couche d'arrêt (17') pour la formation par gravure des premières tranchées (41), ladite couche d'arrêt (17') étant située à une profondeur sensiblement égale à D1 par rapport à une face supérieure (100) de l'empilement (10).

7. Procédé selon la revendication précédente dans lequel la couche d'arrêt (17') est à base d'InGaAs et présente une épaisseur e' comprise entre 20 nm et 200 nm.

8. Procédé selon l'une quelconque des deux revendications précédentes dans lequel la profondeur D1 est choisie telle que D1 soit supérieure à $1,5.\lambda/4n_{eff}$, avec $\lambda$ une longueur d'onde du rayonnement lumineux monochromatique et $n_{eff}$ un indice effectif.

9. Procédé selon l'une quelconque des revendications précédentes dans lequel les premières tranchées (41) sont distribuées selon un réseau de pas p environ égal à $\lambda/2n_{eff}$, avec $\lambda$ une longueur d'onde du rayonnement lumineux monochromatique et $n_{eff}$ un indice effectif.

10. Procédé selon la revendication précédente dans lequel les premières tranchées (41) présentent une largeur p/2 et un facteur de forme $\varphi$ = p/(2.D1) tel que $0,8 \leq \varphi \leq 1,1$.

11. Procédé selon l'une quelconque des revendications précédentes comprenant en outre, après formation des deuxièmes tranchées (42), une formation d'une couche de passivation (51) sur les parois (43) du laser à cascade quantique.

**Patentansprüche**

1. Verfahren zum Bilden eines verteilten Bragg-Spiegels (65) auf einem Quantenkaskadenlaser, umfassend:

- Bereitstellen eines Stapels (10) von Schichten (11, 12, 13, 14, 15, 16, 17, 17', 18) auf Basis von III-V-Material, der mindestens einen aktiven Bereich (15) umfasst, welcher dazu bestimmt ist, eine monochromatische Lichtstrahlung zu emittieren,

- Abscheiden einer ersten Maskenschicht (31) auf dem Stapel (10),

- Bilden von ersten Mustern (310) in der ersten Maskenschicht (31),

- Bilden von ersten Gräben (41) im Stapel (10) entsprechend einer ersten Tiefe D1 ab den ersten Maskenmustern (310), wobei sich die ersten Gräben (41) im Wesentlichen in einer ersten Richtung (x) erstrecken und dazu bestimmt sind, Strukturen (5) des verteilten Bragg-Spiegels (65) zu bilden,
- Abscheiden einer zweiten Maskenschicht (32) mindestens in den ersten Gräben (41),
- Bilden von zweiten Mustern (320) in der zweiten Maskenschicht (32) beiderseits der ersten Muster (310),
- Bilden von zweiten Gräben (42) im Stapel (10) entsprechend einer zweiten Tiefe D2, die größer ist als die erste Tiefe D1, ab den zweiten Maskenmustern (320), wobei sich die zweiten Gräben (42) im Wesentlichen in einer zweiten Richtung (y) senkrecht zur ersten Richtung (x) erstrecken und dazu bestimmt sind, Wände (43) des Quantenkaskadenlasers zu bilden,
- Entfernen der zweiten Maskenschicht (32) in den ersten Gräben (41),
- Füllen der ersten Gräben (41) mit mindestens einem Metallmaterial,

wobei das Verfahren **dadurch gekennzeichnet ist, dass** es weiter umfasst:

- vor dem Abscheiden der zweiten Maskenschicht (32), Bilden einer zwischenliegenden Opferschicht (34) mindestens in den ersten Gräben (41), und
- vor dem Füllen der ersten Gräben (41) mit dem mindestens einen Metallmaterial und nach dem Entfernen der zweiten Maskenschicht (32) in den ersten Gräben (41), Entfernen der zwischenliegenden Opferschicht (34), um Rückstände (40) der zweiten Maskenschicht (32), die am Ende des Schrittes des Entfernens der zweiten Maskenschicht (32) in den ersten Gräben (41) in den ersten Gräben (41) zurückbleiben, durch Ablösen zu entfernen.

2. Verfahren nach dem vorstehenden Anspruch, wobei die zwischenliegende Opferschicht (34) auf Basis von Siliziumoxid ist.

3. Verfahren nach einem der vorstehenden Ansprüche, wobei die zweite Maskenschicht (32) auf Basis von Siliziumnitrid ist.

4. Verfahren nach einem der vorstehenden Ansprüche, wobei die zwischenliegende Opferschicht (34) eine Dicke e aufweist, die im Wesentlichen konstant ist und im Bereich zwischen 100 nm und 300 nm liegt.

5. Verfahren nach einem der vorstehenden Ansprüche, wobei das Entfernen der zwischenliegenden Opferschicht (34) durch Nassätzen mit einer gepufferten Lösung auf Basis von Fluorwasserstoffsäure erfolgt.

6. Verfahren nach einem der vorstehenden Ansprüche, wobei der Stapel (10) eine Stoppschicht (17') für das Bilden der ersten Gräben (41) durch Ätzen umfasst, wobei sich die Stoppschicht (17') in Bezug auf eine Oberseite (100) des Stapels (10) in einer Tiefe befindet, die im Wesentlichen gleich D1 ist.

7. Verfahren nach dem vorstehenden Anspruch, wobei die Stoppschicht (17') auf Basis von InGaAs ist und eine Dicke e' im Bereich zwischen 20 nm und 200 nm aufweist.

8. Verfahren nach einem der zwei vorstehenden Ansprüche, wobei die Tiefe D1 so ausgewählt ist, dass D1 größer als $1{,}5.\lambda/4n_{eff}$ ist, wobei $\lambda$ eine Wellenlänge der monochromatischen Lichtstrahlung ist, und $n_{eff}$ ein effektiver Index ist.

9. Verfahren nach einem der vorstehenden Ansprüche, wobei die ersten Gräben (41) entsprechend einem Netz mit Teilung p von etwa gleich $\lambda/2n_{eff}$ verteilt sind, wobei $\lambda$ eine Wellenlänge der monochromatischen Lichtstrahlung ist, und $n_{eff}$ ein effektiver Index ist.

10. Verfahren nach dem vorstehenden Anspruch, wobei die ersten Gräben (41) eine Breite p/2 und einen Formfaktor $\varphi = p/(2.D1)$ so aufweisen, dass $0{,}8 \leq \varphi \leq 1{,}1$.

11. Verfahren nach einem der vorstehenden Ansprüche, das nach dem Bilden der zweiten Gräben (42) weiter das Bilden einer Passivierungsschicht (51) an den Wänden (43) des Quantenkaskadenlasers umfasst.

**Claims**

1. A method for forming a distributed Bragg mirror (65) on a quantum cascade laser, comprising:

- providing a stack (10) of layers (11, 12, 13, 14, 15, 16, 17, 17', 18) based on materials III-V comprising at least one active region (15) for emitting a monochromatic light radiation,
- depositing a first masking layer (31) onto said stack (10),
- forming first patterns (310) in the first masking layer (31),
- forming first trenches (41) in the stack (10), at a first depth D1, from the first masking patterns (310), said first trenches (41) mainly extending along a first direction (x) and being intended to form structures (5) of the distributed Bragg mirror (65),
- depositing a second masking layer (32) at least into the first trenches (41),
- forming second patterns (320) in the second masking layer (32), on either side of the first patterns (310),
- forming second trenches (42) in the stack (10), at a second depth D2 greater than the first depth D1, from the second masking patterns (320), said second trenches (42) mainly extending along a second direction (y) perpendicular to the first direction (x) and being intended to form walls (43) of the quantum cascade laser,
- removing the second masking layer (32) from the first trenches (41),
- filling said first trenches (41) with at least one metal material,

said method being **characterised in that** it further comprises:

- before depositing the second masking layer (32), forming a sacrificial interlayer (34) at least in the first trenches (41), and
- before filling said first trenches (41) with at least one metal material and after removing the second masking layer (32) from the first trenches (41), removing said sacrificial interlayer (34) so as to remove by lifting off residues (40) of the second masking layer (32) remaining in the first trenches (41) at the end of the step of removing the second masking layer (32) from the first trenches (41).

2. The method according to the preceding claim, wherein the sacrificial interlayer (34) is based on silicon oxide.

3. The method according to any of the preceding claims, wherein the second masking layer (32) is based on silicon nitride.

4. The method according to any of the preceding claims, wherein the sacrificial interlayer (34) has a thickness e substantially constant of between 100 nm and 300 nm.

5. The method according to any of the preceding claims, wherein removing the sacrificial interlayer (34) is performed by wet etching from a hydrofluoric acid based buffered solution.

6. The method according to any of the preceding claims, wherein the stack (10) comprises a barrier layer (17') for forming the first trenches (41) by etching, said barrier layer (17') being located at a depth substantially equal to D1 relative to an upper face (100) of the stack (10).

7. The method according to the preceding claim, wherein the barrier layer (17') is based on InGaAs and has a thickness e' of between 20 nm and 200 nm.

8. The method according to any of the two preceding claims, wherein the depth D1 is selected such that D1 is greater than $1.5\ \lambda/4n_{eff}$, with $\lambda$ being a wavelength of the monochromatic light radiation and $n_{eff}$ an effective index.

9. The method according to any of the preceding claims, wherein the first trenches (41) are distributed in a grating with a pitch p approximately equal to $\lambda/2n_{eff}$, with $\lambda$ being a wavelength of the monochromatic light radiation and $n_{eff}$ an effective index.

10. The method according to the preceding claim, wherein the first trenches (41) have a width p/2 and a form factor $\varphi = p/(2.\ D1)$ such that $0.8 \leq \varphi \leq 1.1$.

11. The method according to any of the preceding claims, further comprising, after forming a second trenches (42), forming a passivation layer (51) on the walls (43) of the quantum cascade laser.

FIG. 1

61    6    40

60

h                                        40

10"

z

x ⊙ → y

l=p/2

p

FIG. 2

61    6    5    6

60

h

10"

z

x ⊙ → y

l=p/2

p

FIG. 3

A-A

FIG. 4A

B-B

FIG. 4B

A-A                                                                FIG. 5A

B-B                                                                FIG. 5B

32
34
31
18
17 } 10"
16
15
14
13 } 10'
12
11

10

20

D1

z
x  y

A-A

FIG. 6A

32,320

18
17 } 10"
16
15
14
13 } 10'
12
11

10

20

z
y  x

B-B

FIG. 6B

32
34
31
18 ⎫
17 ⎬ 10"
16 ⎭
D1
15
14 ⎫
10
13 ⎬ 10'
12 ⎭
11

z
x ⊙ → y

20

A-A

FIG. 7A

42   43   31   34   320   43   42

D2

13
12
11

z
y ⊗ → x

B-B

FIG. 7B

41    40

D1

18
17    10"
16
15
14
13    10'
12
11

10

20

z
x  y

A-A

FIG. 8A

51    34    50

50'

z
y  x

B-B

FIG. 8B

A-A                                                      FIG. 9A

B-B                                                      FIG. 9B

A-A                                    FIG. 10A

B-B                                    FIG. 10B

A-A

FIG. 11

## RÉFÉRENCES CITÉES DANS LA DESCRIPTION

### Documents brevets cités dans la description

- US 7567606 B2

### Littérature non-brevet citée dans la description

- **COUTARD et al.** Volume Fabrication of Quantum Cascade Lasers on 200 mm-CMOS pilot line. *Scientific Reports | Nature research,* 2020

- **CARRAS, M. et al.** Top grating index-coupled distributed feedback quantum cascade lasers. *Appl. Phys. Lett.,* 2008, vol. 93, 011109